# EUROPEAN PATENT APPLICATION

(11) **EP 1 887 607 A2**
(43) Date of publication of application: **13.02.2008**
(21) Application number: 07113936.4
(22) Date of filing: 07.08.2007
(51) Int. Cl.: H01J 17/49, H01J 9/20, H05K 9/00

(54) **Plasma display panel and method for manufacturing the same**

(30) Priority: 09.08.2006 KR 20060075261
(71) Applicant: LG Electronics Inc., Seoul 150-721 (KR)
(72) Inventor: Lee, Myung Won, 137-724 Seoul (KR); Bae, Bum Jin, 137-724 Seoul (KR); Kang, Nam Seok, 137-724, SEOUL (KR); Kim, Jae Seok, 137-724 Seoul (KR); Ryu, Byung Gil, 137-724 Seoul (KR)
(74) Representative: Cabinet Plasseraud

(57) **Abstract**

A front filter of a plasma display panel is disclosed. The plasma display panel includes a first panel (210) including address electrodes (220), a dielectric (230), phosphors (250), and barrier ribs (240), a second panel (110) assembled to the first panel such that the barrier ribs are interposed between the first and second panels, the second panel including sustain electrode pairs (120,130), a dielectric (140), and a protect layer (150), and a front filter (100) directly coupled to the second panel, the front filter including an electromagnetic interference (EMI) shield film (100a) formed by patterning a conductive material, and a base polymer (100b) filled among patterns of the EMI shield film.

## Description

This application claims the benefit of Korean Patent Application No.10-2006-0075261, filed on August 9, 2006, which is hereby incorporated by reference as if fully set forth herein.

### BACKGROUND OF THE INVENTION

### Field of the Invention

The present invention relates to a plasma display panel, and more particularly, to a front filter of a plasma display panel.

### Discussion of the Related Art

In accordance with the advent of an age of multimedia, development of a display device capable of more finely rendering colors more approximate to natural colors while having a larger size is being required. However, the current cathode ray tubes (CRTs) have a limitation in realizing a large screen of 40 inches or more. For this reason, liquid crystal displays (LCDs), plasma display panels (PDPs), and projection televisions (TVs) are being rapidly developed so that the applications thereof can be extended to a high-quality image field.

In the case of a PDP, electromagnetic waves harmful to the human body are generated during a driving operation of the PDP. For this reason, a front filter may be installed on a front surface of a panel in the PDP, in order to shield the electromagnetic waves.

Hereinafter, the front filter of the PDP and the problems thereof will be described.

A front filter, which is of a glass type or a film type, is provided at the front surface of a PDP. The front filter includes films functioning to shield electromagnetic interference (EMI) waves and near infrared rays (NIRs), to perform color correction, and to prevent reflection of light externally incident to the PDP.

Conventionally, a glass type front filter is mainly used. Although the glass type front film can prevent the front film from being damaged due to an external impact, it has drawbacks of a large thickness, a heavy weight, and high manufacturing costs. In order to overcome such drawbacks, a film type front filter has often been proposed.

The structure of an EMI shield film, which is included in the front filter, will be described hereinafter. The EMI shield film is configured by a conductive material formed on a base film in the form of a mesh. The conductive material may be supported by a frame. The mesh structure is formed by patterning a film of the conductive material on a glass or a base film made of polyethylene terephthalate (PET), using a photolithography, an etching process, or a sputtering process.

However, the above-mentioned conventional front filter used in PDPs has the following problems.

First, since the front filter is constituted by a plurality of layers including an EMI shield film, an NIR shield film, etc., it involves complex processes and an increase in manufacturing costs.

Second, since the front filter is bonded to the front glass in a state of being supported by a glass or a film, and, it involves an increase in weight and an increase in manufacturing costs.

Third, the front filter exhibits a low impact absorption against an impact applied to the front glass of the PDP.

Fourth, misalignment of lattice spacings or deformation of lattice patterns may easily occur when the front filter is bonded to the upper glass of the PDP, so that the visible light transmittance of the PDP may be degraded.

### SUMMARY OF THE INVENTION

Accordingly, the present invention is directed to a plasma display panel and a method for manufacturing the same that substantially obviate one or more problems due to limitations and disadvantages of the related art.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a plasma display panel comprises: a first panel including address electrodes, a dielectric, phosphors, and barrier ribs; a second panel assembled to the first panel such that the barrier ribs are interposed between the first and second panels, the second panel including sustain electrode pairs, a dielectric, and a protect layer; and a front filter directly coupled to the second panel, the front filter including an electromagnetic interference (EMI) shield film formed by patterning a conductive material, and a base polymer filled among patterns of the EMI shield film.

In another aspect of the present invention, a plasma display panel comprises: a first panel including address electrodes, a dielectric, phosphors, and barrier ribs; a second panel assembled to the first panel such that the barrier ribs are interposed between the first and second panels, the second panel including sustain electrode pairs, a dielectric, and a protect layer film; and a front filter directly coupled to the second panel, the front filter including a first layer made of a transparent conductive material, and a second layer made of a base polymer.

In still another aspect of the present invention, a method for manufacturing a plasma display panel comprises: forming address electrodes, a dielectric, barrier ribs, and phosphors on a first substrate; forming sustain electrode pairs, a dielectric, and a protect layer on a second substrate; assembling the second substrate to the first substrate such that the barrier ribs are interposed between the first and second substrates; and forming, over the second substrate, a front filter including a conductive material and a base polymer.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 is a sectional view partially illustrating a plasma display panel according to an exemplary embodiment of the present invention;

FIG. 2 is a perspective view illustrating the plasma display panel according to the illustrated embodiment of the present invention; and

FIG. 3 is a sectional view partially illustrating a plasma display panel according to another embodiment of the present invention.

### DETAILED DESCRIPTION OF THE INVENTION

Reference will now be made in detail to the preferred embodiments of the present invention, examples of which are illustrated in the accompanying drawings.

In the drawings, the thicknesses of various layers or regions are more or less exaggeratively shown to more clearly distinguish each layer or region from other layers or regions. Also, the thickness ratios of the layers shown in the drawings are not actual thickness ratios. Meanwhile, it should be understood that when an element such as a layer, film, region or substrate is referred to as being "on" another element, it can be directly on the other element or intervening elements may also be present.

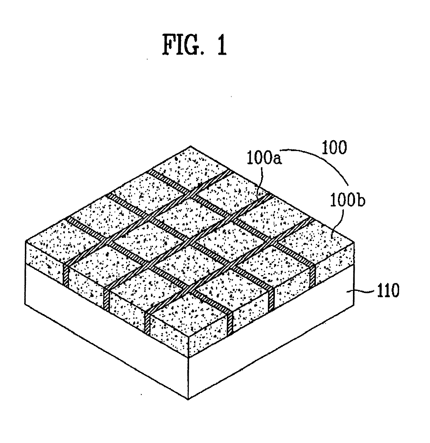

FIG. 1 is a sectional view partially illustrating a plasma display panel according to an exemplary embodiment of the present invention. Referring to FIG. 1, a front substrate 110, and a multi-functional layer 100 formed over the front substrate 110 are shown. The multi-functional layer 100 means a layer having at least two functions. In detail, the multi-functional layer 100 means a single layer constituted by a combination of at least two of functional layers included in a conventional front filter, namely, an electromagnetic interference (EMI) shield film, a near infrared ray (NIR) shield film, a neon-shielding dye layer, and an anti-reflective film. The multi-functional layer 100 may be formed directly on a front glass of the plasma display panel. Alternatively, the multi-functional layer 100 may be attached to a glass or a film, to be prepared in the form of a glass type front filter or a film type front filter.

In the illustrated embodiment of the present invention, the multi-functional layer 100 includes an EMI shield film 100a having a conductive material pattern structure, and a base polymer 100b filled among the patterns of the conductive material pattern structure. In the case of FIG. 1, the EMI shield film 100a is patterned in the form of a mesh. However, the EMI shield film 100a may be patterned to have a stripe type pattern structure. For the conductive material, silver (Ag) or copper (Cu) may be used. The conductive material patterns may have a line width of 10 to 30µm. When the line width of the conductive material patterns is larger than 30µm, light emitted from phosphors may be undesirably shielded. On the other hand, when the line width of the conductive material patterns is smaller than 10µm, the EMI shield effect may be insufficient.

The spacing of the conductive material patterns, each of which extends in the form of a line, should be 150 to 500µm, preferably, about 300µm. The reason why the EMI shield film 100a should have a limited line spacing is similar to the reason why the EMI shield film 100a should have a limited line width. The base polymer 100b contains an NIR shielding agent, a neon light shielding agent, a color correcting agent, etc. The thickness of the base polymer 100b may be 10 to 30µm. When the base polymer 100b is excessively thick, there may be problems of an increase in volume and an increase in weight. On the other hand, when the base polymer 100b is excessively thin, the contents of the NIR shielding agent, etc. may be insufficient.

For the NIR shielding agent, a diimonium-based dye, a phthalocyanine-based dye, a naphthalocyanine-based dye, or a metal-complex-based dye may be used. For the neon light shielding agent, a porphyrin-based compound or a cyanine-based compound may be used. The base polymer 100b may be bonded to the front substrate 110 by an adhesive. Alternatively, the base polymer 100b itself may contain an adhesive. The adhesive may be an acryl-based adhesive, that is, a butyl acrylate/hydroxyl ethyl metacrylate copolymer adhesive or a butyl acrylate/acrylic acid copolymer adhesive. An anti-reflective layer (not shown) may be formed over the multi-functional layer 100, to prevent a reflection of external light incident to the front filter, and thus to achieve an enhancement in contrast.

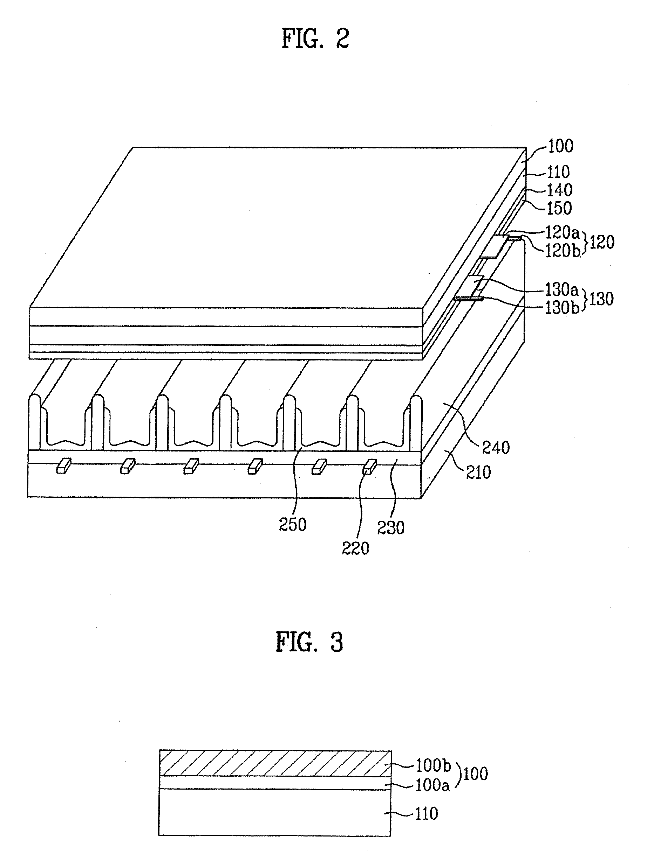

FIG. 2 is a perspective view illustrating the plasma display panel according to the illustrated embodiment of the present invention. In FIG. 2, the above-described front filter (multi-functional layer) is simply shown in the form of a single layer 100.

As shown in FIG. 2, the plasma display panel of the present invention includes display electrodes 120 and 130 formed in pairs on the front substrate 110 while extending in one direction, to constitute sustain electrode pairs. Each display electrode 120 or 130 includes a transparent electrode 120a or 130a typically made of indium tin oxide (ITO), and a bus electrode 120b or 130b typically made of a metal material. The plasma display panel also includes a dielectric layer 140 and a protect layer film 150 sequentially formed, in this order, over the overall surface of the front substrate 110, to cover the display electrodes 120 and 130.

The front substrate 110 is prepared by machining a glass for a display substrate, using milling and cleaning. The transparent electrodes 120a and 130a are formed in accordance with a lift-off method using a sputtering process or a photo-etching process. The bus electrodes 120b and 130b are made of silver (Ag). A black matrix may be formed on the sustain electrode pairs. The black matrix may be made of a material including a glass exhibiting a low melting point and a black pigment.

The dielectric layer 140, which is an upper dielectric layer, is formed over the front substrate 110 provided with the transparent electrodes and bus electrodes. The upper dielectric layer 140 is made of a transparent glass having a low melting point. The protect layer 150 is formed over the upper dielectric layer 140, using a magnesium oxide. The protect layer 150 functions to protect the upper dielectric layer 140 from an impact of positive (+) ions during an electrical discharge, while functioning to increase the emission of secondary electrons.

The plasma display panel of the present invention further includes a back substrate 210. Address electrodes 220 are formed on one surface of the back substrate 210 such that they extend in a direction perpendicular to the extension direction of the display electrodes 120 and 130. A white dielectric layer 230 is also formed over the overall surface of the back substrate 210, to cover the address electrodes 220. The white dielectric layer 230 formed over the overall surface of the back substrate 210 is made of a glass having a low melting point, and a filler such as TiO₂. The formation of the white dielectric layer 230 is achieved by laminating a layer over the back substrate 210 in accordance with a printing method or a film laminating method, and curing the laminated layer.

Barrier ribs 240 are formed on the white dielectric layer 230 such that each barrier rib 240 is arranged between the adjacent address electrodes 220. The barrier ribs 240 may be of a stripe type, a well type, or a delta type. Red (R), green (G), and blue (B) phosphor layers 250 are formed on the white dielectric layer 230 such that each phosphor layer 250 is arranged between the adjacent barrier ribs 240.

Discharge cells are defined in regions where the address electrodes 220 on the back substrate 210 intersect the display electrodes 120 and 130 on the front substrate 110. When an address voltage is applied between one address electrode 220 and one display electrode 120 or 130, an address discharge occurs in the associated cell, so that a wall voltage is generated in the cell. A sustain voltage is subsequently applied to the display electrodes 120 and 130, a sustain discharge occurs in the cell, at which the wall voltage has been generated. Vacuum ultraviolet rays generated in accordance with the sustain discharge excite the phosphors in the associated cell, so that the phosphors emit light. Thus, visible rays are emitted through the transparent front substrate 110. Thus, an image is displayed on the plasma display panel.

FIG. 3 is a sectional view partially illustrating a plasma display panel according to another embodiment of the present invention. Similarly to the embodiment of FIG. 1, the plasma display panel of this embodiment includes a front substrate 110, and a multi-functional layer 100 formed over the front substrate 110. In this case, however, a transparent conductive material, such as indium tin oxide (ITO), is laminated over the front substrate 110, to form an electromagnetic interference (EMI) shield film 100a, different from the afore-mentioned embodiment. A base polymer 100b is laminated over the EMI shield film 100a. The composition of the base polymer 100b is identical to that of the afore-mentioned embodiment. Also, the EMI shield film 100a may not be formed over the front substrate 110, but may be formed over a glass or a film, as described above.

Hereinafter, the functions of the plasma display panels according to the above-described embodiments of the present invention will be described.

Since the plasma display panel according to each embodiment of the present invention includes a front filter including a single layer having multiple functions, it is possible to reduce the manufacturing costs and to simplify the manufacturing process, as compared to conventional plasma display panels. Also, it is possible to form the front filter directly on the front glass.

Hereinafter, an embodiment of a method for manufacturing a plasma display panel in accordance with the present invention will be described.

First, transparent electrodes and bus electrodes are formed on a front substrate. The front substrate is prepared by milling and cleaning a glass or a sodalime glass for a display substrate. The transparent electrodes are formed, using ITO or SnO2, in accordance with a photo-etching method using a sputtering process or a lift-off method using a CVD process. The bus electrodes are formed, using a material such as silver (Ag), in accordance with a screen printing method or a photosensitive paste method. A black matrix may be formed on the sustain electrode pairs. The black matrix may be formed, using a low-melting-point glass and a black pigment, in accordance with a screen printing method or a photosensitive paste method.

Thereafter, a dielectric is formed over the front substrate provided with the transparent electrodes and bus electrodes. The formation of the dielectric may be achieved by laminating a material including a low-melting-point glass, etc. in accordance with a screen printing method or a coating method, or laminating a green sheet. A protect layer is then deposited over the dielectric. The formation of the protect layer may be achieved by depositing a magnesium oxide, etc. in accordance with an electron beam deposition process, a sputtering process, or an ion plating process.

Meanwhile, address electrodes are formed on the back substrate. The back substrate is prepared by milling and cleaning a glass or a sodalime glass for a display substrate. The address electrodes are formed, using silver (Ag), in accordance with a screen printing method, a photosensitive paste method, or a photo-etching method. The photo-etching method is carried out after completion of a sputtering process. A dielectric is then formed over the back substrate provided with the address electrodes. The formation of the dielectric may be achieved by laminating a material including a low-melting-point glass and a filler such as TiO₂ in accordance with a screen printing method or laminating a green sheet. It is preferred that the back-substrate-side dielectric exhibit white, in order to achieve an enhancement in the brightness of the plasma display panel.

Thereafter, barrier ribs are formed to separate discharge cells from one another. The material of the barrier ribs includes a parent glass and a filler. The parent glass may include PbO and SiO₂, or may include B₂O₃ and Al₂O₃. The filler may include TiO₂ and Al₂O₃.

A black top material is coated over the barrier ribs. The black top material includes a solvent, inorganic powder, and an additive. The inorganic powder includes glass frits and a black pigment. The layers of the barrier rib material and black top material are patterned, to form the barrier ribs and black tops.

The patterning process involves masking, light exposure, and development. That is, a mask is arranged to cover regions corresponding to the address electrodes, and a light exposure is subsequently carried out. When development and curing processes are sequentially carried out, only the light-exposed portions of the barrier rib material layer and black top material layer remain. Thus, the barrier ribs and black tops are formed. When a photoresist material is contained in the black top material, it is possible to more easily achieve the patterning of the barrier rib and black top materials. When the barrier rib and black top materials are simultaneously cured, the binding force between the parent glass of the barrier rib material and the inorganic powder of the black top material increases. In this case, accordingly, an enhancement in durability is expected.

Thereafter, phosphors are coated over the surfaces of the back-substrate-side dielectric facing discharge spaces and the side surfaces of the barrier ribs. The coating of the phosphors is carried out such that R, G, and B phosphors are sequentially coated in each discharge cell. The coating is carried out using a screen printing method or a photosensitive paste method.

Subsequently, an upper panel including the front substrate, is assembled to a lower panel including the back substrate, such that the barrier ribs are interposed between the upper and lower panels. The upper and lower panels are then sealed. The space between the upper and lower panels is then evacuated, to remove impurities from the space. Thereafter, a discharge gas is injected into the space.

Now, the process for forming the front filter on the front substrate will be described. The front filter may be formed after the assembly of the upper and lower panels. Alternatively, the front filter may be formed on the upper panel before the assembly of the upper and lower panels.

First, an EMI shield film is formed over the front substrate of the plasma display panel. It is preferred that the formation of the EMI shield film be achieved through patterning of a conductive material. In this case, it is preferred that the conductive material be patterned to have a mesh type structure or a stripe type structure. A base polymer is formed among the conductive material patterns. The formation of the base polymer may be achieved using a spin coating process or a bar coating process. As described above, the base polymer preferably has a multi-functional layer structure. In the illustrated embodiment, the base polymer may contain a mixture of an NIR shielding agent, a neon light shielding agent, and a color correcting agent. The base polymer is then cured. This embodiment is a method for manufacturing the above-described plasma display panel. Accordingly, the base polymer is formed to have a thickness of 10 to 30µm. Also, the base polymer may contain an adhesive. An anti-reflective layer may be formed over the base polymer. The compositions of the base polymer, adhesive, and anti-reflective layer are identical to those of the above-described plasma display panel.

Although the adhesive has been described as being contained in the base polymer, it may have the form of a separate layer. In this case, the formation of the adhesive layer is carried out as follows.

In order to prepare the adhesive, 70 to 80% of acrylic acid 2-ethyl hexyl as a main monomer, 20 to 30% of ethylene unsaturated monomer acrylic acid 2-hydroxy ethyl co-polymerizable with the main monomer, and 0.01 to 0.5% of 2.2-dimethoxy-2-phenylacetophenone as a photo-polymerization initiator are put into a reaction vessel equipped with an ultraviolet irradiating device and a stirring device. The mixture is polymerized in accordance with ultraviolet irradiation, to produce a polymer/monomer mixture liquid exhibiting a polymerization degree of about 10wt%. 0.2% of trimethylol propane triacrylate and 0.1% of 2.2-dimethoxy-2-phenylacetophenon are added to the liquid prepared in the above-described process, to produce a photo-polymerizable composition.

Thereafter, the photo-polymerizable composition is coated over a material such as DR-101 or PSX. A polyester-based release film, as a cover, is attached to the photo-polymerizable composition coating. Thereafter, ultraviolet rays of about 1,000mJ/cm² are irradiated onto the photo-polymerizable composition coating, to photo-polymerize the photo-polymerizable composition, and thus to obtain an adhesive.

Another embodiment of the preparation of an adhesive is a method for preparing a silicon adhesive. As an example of the silicon adhesive, there is a method for forming a film, which contains a material capable of achieving an increase in adhering force, to a certain thickness over a substrate containing 43.1% of polydimethyl siloxane, and drying the film, to obtain a desired adhering force of the film to the substrate.

Hereinafter, an embodiment of a method for manufacturing a silicon pressure sensitive adhesive (PSA) will be described. First, 5 raw materials, namely, a solution prepared by dissolving methylpolysiloxane, which contains (CH₃)₃SiO₄ and (HO)_{α}SiO_{(4-α)/2} in a mole ratio of 0.7 : 1, and has a hydroxyl radical content of less than 1%, in xylene in a concentration of 60%, a polydimethylsiloxane gum, which exhibits a viscosity of 10kPa.S or more, has a vinyl radical content of less than 0.03%, and has a terminal dimethylvinylsiloxy group, Me₂SiO(Me₂SiO)₃(MeHSiO)₅SiMe₃, phenylbutynol (reaction inhibitor), and xylene, are prepared. Thereafter, the prepared 5 raw materials are mixed in a ratio of 55 : 25 : 0.4 : 0.06 : 57.5. Thereafter, a chloro-platinic acid-vinylsiloxane complex is added to the mixture solution in an amount corresponding to 0.9wt% of the xylene solution. At this time, the ratio between SiH and SiVi is adjusted to be 20 : 1. Meanwhile, another solution is prepared by dissolving methylpolysiloxane, which contains (CH₃)₃SiO_{1/2} and (R₂O)ₐSiO_{(4-a)/2} in a mole ratio of 1.2 : 1, and has a hydroxyl radical content of less than 1% and an ethoxy radical content of less than 1%, in xylene in a concentration of 70%. The resultant solution is then mixed with the mixture solution of the above-described 5 materials, to prepare a silicon PSA.

Hereinafter, another method for manufacturing a front filter of a plasma display panel in accordance with the present invention will be described.

First, the front filter is formed by forming an EMI shield film is formed over the front substrate in accordance with sputtering of ITO, forming a base polymer over the EMI shield film, and curing the base polymer. The composition of the base polymer is identical to that of the above-described embodiments. This embodiment is identical to the above-described embodiments, only except that the EMI shield film is formed in the form a separate layer through sputtering of ITO.

It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

## Claims

1. A plasma display panel comprising:
a first panel including address electrodes, a dielectric, phosphors, and barrier ribs;
a second panel assembled to the first panel such that the barrier ribs are interposed between the first and second panels, the second panel including sustain electrode pairs, a dielectric, and a protect layer; and
a front filter directly coupled to the second panel, the front filter including an electromagnetic interference (EMI) shield film formed by patterning a conductive material, and a base polymer filled among patterns of the EMI shield film.

2. The plasma display panel according to claim 1, wherein the base polymer comprises at least one of a near infrared ray shielding agent, a color correcting agent, and a neon light shielding agent.

3. The plasma display panel according to claim 2, wherein the near infrared ray shielding agent is selected from the group consisting of a diimonium-based dye, a phthalocyanine-based dye, a naphthalocyanine-based dye, and a metal-complex-based dye.

4. The plasma display panel according to claim 2, wherein the neon light shielding agent is selected from the group consisting of a porphyrin-based compound and a cyanine-based compound.

5. The plasma display panel according to claim 1, further comprising:
an anti-reflective layer formed over the base polymer.

6. The plasma display panel according to claim 2, wherein the base polymer further comprises an adhesive.

7. The plasma display panel according to claim 6, wherein the adhesive is an acryl-based adhesive comprising a butyl acrylate/hydroxyl ethyl metacrylate copolymer adhesive or a butyl acrylate/acrylic acid copolymer adhesive.

8. The plasma display panel according to claim 1, wherein the EMI shield film has a line width of 10 to 30µm.

9. The plasma display panel according to claim 1, wherein the base polymer has a thickness of 10 to 30µm.

10. The plasma display panel according to claim 1, wherein the front filter is of a film type or a glass type.

11. A plasma display panel comprising:
a first panel including address electrodes, a dielectric, phosphors, and barrier ribs;
a second panel assembled to the first panel such that the barrier ribs are interposed between the first and second panels, the second panel including sustain electrode pairs, a dielectric, and a protect layer; and
a front filter directly coupled to the second panel, the front filter including a first layer made of a transparent conductive material, and a second layer made of a base polymer.

12. The plasma display panel according to claim 11, wherein the transparent conductive material is indium tin oxide (ITO).

13. A method for manufacturing a plasma display panel, comprising:
forming address electrodes, a dielectric, barrier ribs, and phosphors on a first substrate;
forming sustain electrode pairs, a dielectric, and a protect layer on a second substrate;
assembling the second substrate to the first substrate such that the barrier ribs are interposed between the first and second substrates; and
forming, over the second substrate, a front filter including a conductive material and a base polymer.

14. The method according to claim 13, wherein the step of forming the front filter comprises:
patterning the conductive material on the second substrate, to form an electromagnetic interference (EMI) shield film; and
injecting the base polymer among patterns of the EMI shield film, to form the front filter.

15. The method according to claim 14, wherein the EMI shield film is formed by arranging a mask on the second substrate, and performing a sputtering process, to pattern the conductive material.

16. The method according to claim 14, wherein the EMI shield film is printed in accordance with an ink jet method or an offset method.

17. The method according to claim 13, wherein the step of forming the front filter comprises:
forming a first layer over the second substrate, using a transparent conductive material; and
forming a second layer over the first layer, using a base polymer.

18. The method according to claim 13, wherein the front filter is coupled to the second substrate by an adhesive.

19. The method according to claim 13, wherein the front filter is of a film type or a glass type, and is coupled to the second substrate.

20. The method according to claim 13, further comprising:
forming an anti-reflective layer over the base polymer.
